# EUROPEAN PATENT APPLICATION

(11) **EP 4 579 941 A1**
(43) Date of publication of application: **02.07.2025**
(21) Application number: 23856885.1
(22) Date of filing: 31.03.2023
(51) Int. Cl.: H01P 1/18

(54) **DIGITAL PHASE SHIFTER**

(30) Priority: 23.08.2022 JP 2022132523
(71) Applicant: Fujikura Ltd., Tokyo 135-8512 (JP)
(72) Inventor: UEMICHI, Yusuke, Sakura-shi, Chiba 285-8550 (JP)
(74) Representative: Lavoix
(86) International application number: PCT/JP2023/013596
(87) International publication number: WO 2024/042765

(57) **Abstract**

A digital phase shifter includes a plurality of digital phase shift circuit groups in which a plurality of digital phase shift circuits are connected in cascade, and one or more bend type connection portions that connect two of the digital phase shift circuit groups to each other, in which a connection portion includes a coil that is connected in series between a signal line of a first digital phase shift circuit and a signal line of a second digital phase shift circuit, of two of the digital phase shift circuits, a pair of capacitors that are connected in parallel on both sides of the coil, and a pair of electronic switches that are each provided on one end side of the pair of capacitors and that switch whether or not to ground the one end side of the pair of capacitors.

## Description

### TECHNICAL FIELD

The present invention relates to a digital phase shifter.

Priority is claimed on Japanese Patent Application No. 2022-132523, filed August 23, 2022, the content of which is incorporated herein by reference.

### BACKGROUND ART

In the following Non Patent Document 1, a digital control type phase shift circuit (a digital phase shift circuit) for a high-frequency signal such as a microwave, quasi-millimeter wave, or millimeter wave is disclosed. The digital phase shifter is mounted on a semiconductor substrate in a state in which a large number of the digital phase shift circuits are connected in cascade. That is, the digital phase shift circuit is a unit in the actual configuration of the digital phase shifter, and a desired function is exhibited by connecting several tens of the digital phase shift circuits in cascade.

When the configuration of the digital phase shifter is a configuration in which the digital phase shift circuits are connected in a row, the length of the digital phase shifter increases. In order to shorten the length of the digital phase shifter, it is conceivable to configure the digital phase shifter to be bent using a connection portion such as a bend type line or the like that has a bent structure.

### Citation List

### Non Patent Documents

Non Patent Document 1: A Ka-band Digitally-Controlled Phase Shifter with sub-degree Phase Precision (2016, IEEE, RFIC)

### SUMMARY OF INVENTION

### Technical Problem

When a phase shifting function is added to the connection portion, it is conceivable to add the digital phase shift circuit to the connection portion, but there is a problem in that the size of the connection portion is increased.

The present invention has been made in view of the above circumstances, and provides a digital phase shifter capable of adding a phase shifting function to a connection portion and adjusting a phase shift amount while an increase in size of the connection portion is suppressed.

### Solution to Problem

A digital phase shifter according to a first aspect of the present invention includes a plurality of digital phase shift circuit groups in which a plurality of digital phase shift circuits are connected in cascade, and one or more bend type connection portions that connect two of the digital phase shift circuit groups to each other, in which the digital phase shift circuit includes at least a signal line, a pair of inner side lines that are provided on both sides of the signal line, a pair of outer side lines that are provided outside the pair of inner side lines, a first ground conductor that is connected to one end of each of the pair of inner side lines and the pair of outer side lines, a second ground conductor that is connected to the other end of each of the pair of outer side lines, and a pair of first electronic switches that are each provided between the other end of each of the pair of inner side lines and the second ground conductor and is a circuit that is set in a low delay mode in which a return current flows through the pair of inner side lines or a high delay mode in which a return current flows through the pair of outer side lines, wherein the connection portion includes a first connection circuit that connects the signal line of a first digital phase shift circuit to the signal line of a second digital phase shift circuit, of two of the digital phase shift circuits, and a connection line that electrically connects the pair of outer side lines of the first digital phase shift circuit to the pair of outer side lines of the second digital phase shift circuit, and the first connection circuit includes a first coil that is connected in series between the signal line of the first digital phase shift circuit and the signal line of the second digital phase shift circuit, a pair of first capacitors that are connected in parallel on both sides of the first coil, and a pair of second electronic switches that are each provided on one end side of the pair of first capacitors and that switch whether or not to ground the one end side of the pair of first capacitors.

In the digital phase shifter according to the first aspect of the present invention, in the first connection circuit of the connection portion that connects two digital phase shift circuit groups to each other, the first coil is connected in series, and the pair of first capacitors are connected in parallel on both sides of the first coil. Then, a second electronic switch is provided on one end side of each first capacitor, and switches whether or not to perform grounding. As a result, it is possible to add the phase shifting function to the connection portion and to adjust the phase shift amount while an increase in size of the connection portion is suppressed.

According to a second aspect of the present invention, in the digital phase shifter of the first aspect, the connection portion may include a pair of second capacitors that are connected in parallel on both sides of the pair of first capacitors.

A digital phase shifter according to a third aspect of the present invention includes a plurality of digital phase shift circuit groups in which a plurality of digital phase shift circuits are connected in cascade and one or more bend type connection portions that connect two of the digital phase shift circuit groups to each other, in which the digital phase shift circuit includes at least a signal line, a pair of inner side lines that are provided on both sides of the signal line, a pair of outer side lines that are provided outside the pair of inner side lines, a first ground conductor that is connected to one end of each of the pair of inner side lines and the pair of outer side lines, a second ground conductor that is connected to the other end of each of the pair of outer side lines, and a pair of first electronic switches that are each provided between the other end of each of the pair of inner side lines and the second ground conductor, and is a circuit that is set in a low delay mode in which a return current flows through the pair of inner side lines or a high delay mode in which a return current flows through the pair of outer side lines, the connection portion includes a second connection circuit that connects the signal line of a first digital phase shift circuit to the signal line of a second digital phase shift circuit, of two of the digital phase shift circuits, and a connection line that electrically connects the pair of outer side lines of the first digital phase shift circuit to the pair of outer side lines of the second digital phase shift circuit, and the second connection circuit includes a third capacitor that is connected in parallel between the signal line of the first digital phase shift circuit and the signal line of the second digital phase shift circuit, a pair of second coils that are connected in series to both sides of the third capacitor, and a third electronic switch that is provided on one end side of the third capacitor and that switches whether or not to ground the one end side of the third capacitor.

In the digital phase shifter according to the third aspect of the present invention, in the second connection circuit of the connection portion that connects two digital phase shift circuit groups to each other, the third capacitor is connected in parallel, and the pair of second coils is connected in parallel on both sides of the third capacitor. The third electronic switch is provided on one end side of the third capacitor, and switches whether or not to perform grounding. As a result, it is possible to add the phase shifting function to the connection portion and to adjust the phase shift amount while an increase in size of the connection portion is suppressed.

According to a fourth aspect of the present invention, in the digital phase shifter of the third aspect, the connection portion may include a fourth capacitor that is connected in parallel between the pair of second coils.

According to a fifth aspect of the present invention, in the digital phase shifter according to any one of the first to fourth aspects, at least one of the plurality of digital phase shift circuits may be a relaxation circuit that relaxes a distribution of a phase shift amount.

According to a sixth aspect of the present invention, in the digital phase shifter according to any one of the first to fifth aspects, the digital phase shift circuit may include a fifth capacitor that is connected between the signal line and at least one of the first ground conductor and the second ground conductor, and a fourth electronic switch that switches whether or not to connect the fifth capacitor between the signal line and at least one of the first ground conductor and the second ground conductor.

According to a seventh aspect of the present invention, in the digital phase shifter according to any one of the first to sixth aspects, the first ground conductor and the second ground conductor may be configured with a multilayer, and one layer of the ground conductor that is a multilayer may be a ground layer that elongates from the first ground conductor of the first digital phase shift circuit to the second ground conductor of the second digital phase shift circuit to form the connection line.

According to an eighth aspect of the present invention, in the digital phase shifter of the seventh aspect, the ground layer may have a cutout portion.

According to a ninth aspect of the present invention, in the digital phase shifter according to any one of the first to seventh aspects, the pair of inner side lines may include a first inner side line and a second inner side line, and the pair of outer side lines may include a first outer side line electrically connected to the first inner side line and a second outer side line electrically connected to the second inner side line.

### Advantageous Effects of Invention

According to the aspect of the present invention, it is possible to add the phase shifting function to the connection portion and to adjust the phase shift amount while an increase in size of the connection portion is suppressed.

### BRIEF DESCRIPTION OF DRAWINGS

[FIG. 1] A circuit diagram showing a digital phase shifter according to a first embodiment.
[FIG. 2] A perspective view showing a digital phase shift circuit according to the first embodiment.
[FIG. 3] A diagram explaining a high delay mode of the digital phase shift circuit according to the first embodiment.
[FIG. 4] A diagram explaining a low delay mode of the digital phase shift circuit according to the first embodiment.
[FIG. 5] A plan view showing a connection portion according to the first embodiment.
[FIG. 6] A circuit diagram showing the connection portion according to the first embodiment.
[FIG. 7] A plan view showing a modification example of the connection portion according to the first embodiment.
[FIG. 8] A diagram showing a distribution of a phase shift amount of Example 1 of the digital phase shifter according to the first embodiment.
[FIG. 9] A diagram showing a distribution of a phase shift amount of Example 2 of the digital phase shifter according to the first embodiment.
[FIG. 10] A diagram showing a distribution of a phase shift amount of Example 3 of the digital phase shifter according to the first embodiment.
[FIG. 11] A circuit diagram showing a connection portion of a digital phase shifter according to a second embodiment.
[FIG. 12] A circuit diagram showing a connection portion of a digital phase shifter according to a third embodiment.
[FIG. 13] A circuit diagram showing a connection portion of a digital phase shifter according to a fourth embodiment.
[FIG. 14] A diagram explaining a first relaxation circuit of a relaxation circuit according to a fifth embodiment.
[FIG. 15] A diagram explaining a second relaxation circuit of the relaxation circuit according to the fifth embodiment.

### DESCRIPTION OF EMBODIMENTS

Hereinafter, a digital phase shifter according to an embodiment of the present invention will be described in detail with reference to the drawings. In the drawings to be referred to below, for the sake of easy understanding, the dimensions of each member are appropriately changed if necessary.

### (First Embodiment)

### <Digital Phase Shifter>

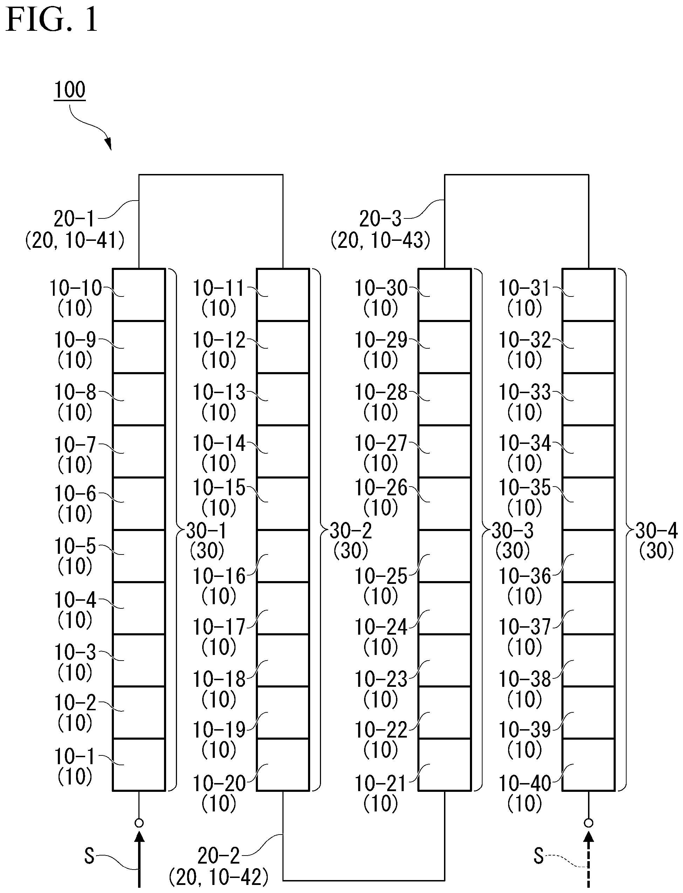

FIG. 1 is a circuit diagram showing a digital phase shifter 100 according to a first embodiment. As shown in FIG. 1, a digital phase shifter 100 of a first embodiment includes a plurality of digital phase shift circuits 10 (10-1 to 10-40) and a plurality of connection portions 20 (20-1 to 20-3). The digital phase shifter 100 performs phase shift on a signal S in a predetermined frequency band by the plurality of digital phase shift circuits 10 that are connected in cascade. The signal S is a high-frequency signal having a frequency band such as a microwave, a quasi-millimeter wave, or a millimeter wave.

The plurality of digital phase shift circuits 10 are electrically connected in cascade. FIG. 1 shows an example in which the 40 digital phase shift circuits 10 (10-1 to 10-40) are connected in cascade, but the number of the digital phase shift circuits 10 that are connected in cascade is optional. In the example shown in FIG. 1, for convenience of description, the 40 digital phase shift circuits 10 that are connected in cascade are denoted by digital phase shift circuits 10-1, 10-2, ..., and 10-40 in the order in which the signal S flows, which is indicated by a solid line arrow in FIG. 1. However, a direction in which the signal S flows may be opposite as indicated by a dotted arrow in FIG. 1.

Here, the plurality of digital phase shift circuits 10 as a unit constitute a digital phase shift circuit group 30. Specifically, the digital phase shift circuits 10-1 to 10-10 from the first to the tenth constitute a digital phase shift circuit group 30-1, and the digital phase shift circuits 10-11 to 10-20 from eleventh to the twentieth constitute a digital phase shift circuit group 30-2. In addition, the digital phase shift circuits 10-21 to 10-30 from the twenty-first to the thirtieth constitute a digital phase shift circuit group 30-3, and the digital phase shift circuits 10-31 to 10-40 from the thirty-first to the fortieth constitute a digital phase shift circuit group 30-4.

In other words, the digital phase shifter 100 includes the digital phase shift circuit group 30-1 in which a plurality of digital phase shift circuits 10-1 to 10-10 are connected in cascade, and the digital phase shift circuit group 30-2 in which a plurality of digital phase shift circuits 10-11 to 10-20 are connected in cascade. In addition, the digital phase shifter 100 includes the digital phase shift circuit group 30-3 in which a plurality of digital phase shift circuits 10-21 to 10-30 are connected in cascade, and the digital phase shift circuit group 30-4 in which a plurality of digital phase shift circuits 10-31 to 10-40 are connected in cascade.

The connection portion 20 has a bend type shape and connects two digital phase shift circuit groups 30. In the example shown in FIG. 1, the connection portion 20 has a 180° bend shape. Specifically, a connection portion 20-1 connects the other end of the digital phase shift circuit group 30-1, which is opposite to one end to which the signal S is input, to one end of the digital phase shift circuit group 30-2. A connection portion 20-2 connects the other end of the digital phase shift circuit group 30-2 to one end of the digital phase shift circuit group 30-3. A connection portion 20-3 connects the other end of the digital phase shift circuit group 30-3 to one end of the digital phase shift circuit group 30-4.

That is, the connection portion 20-1 connects the digital phase shift circuit 10-10 in the digital phase shift circuit group 30-1 to the digital phase shift circuit 10-11 in the digital phase shift circuit group 30-2. The connection portion 20-2 connects the digital phase shift circuit 10-20 in the digital phase shift circuit group 30-2 to the digital phase shift circuit 10-21 in the digital phase shift circuit group 30-3. The connection portion 20-3 connects the digital phase shift circuit 10-30 in the digital phase shift circuit group 30-3 to the digital phase shift circuit 10-31 in the digital phase shift circuit group 30-4.

The digital phase shift circuit group 30-1 and the digital phase shift circuit group 30-2 are connected to each other by the connection portion 20-1, so that the path of the signal S is bent by 180°. In addition, the digital phase shift circuit group 30-2 and the digital phase shift circuit group 30-3 are connected to each other by the connection portion 20-2, so that the path of the signal S is bent by 180°. Similarly, the digital phase shift circuit group 30-3 and the digital phase shift circuit group 30-4 are connected to each other by the connection portion 20-3, so that the path of the signal S is bent by 180°. In this manner, the digital phase shift circuit groups 30-1 to 30-4 are arranged in parallel with each other and are connected in a meander shape through the connection portions 20-1 to 20-3. The details of the connection portion 20 will be described later.

### <Digital Phase Shift Circuit>

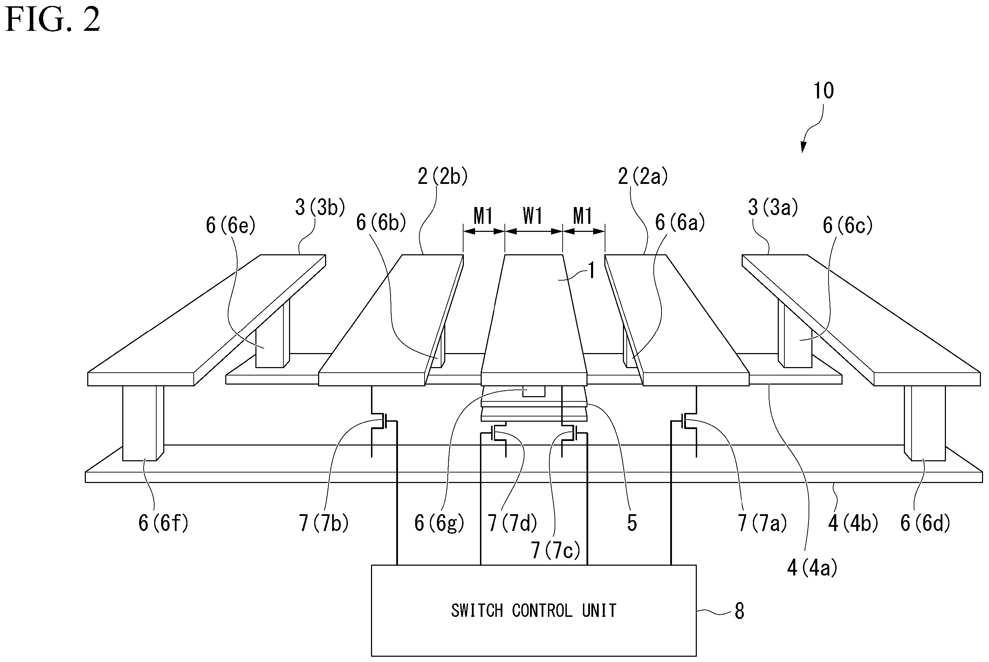

FIG. 2 is a perspective view showing the digital phase shift circuit 10 according to the first embodiment. As shown in FIG. 2, the digital phase shift circuit 10 includes a signal line 1, a pair of inner side lines 2 (a first inner side line 2a and a second inner side line 2b), a pair of outer side lines 3 (a first outer side line 3a and a second outer side line 3b), a pair of ground conductors 4 (a first ground conductor 4a and a second ground conductor 4b), a capacitor 5, a plurality of connection conductors 6, four electronic switches 7 (electronic switches 7a, 7b, 7c, and 7d), and a switch control unit 8.

The signal line 1 is a linear band-shaped conductor extending in a predetermined direction. That is, the signal line 1 is a long plate-shaped conductor having a constant width W1, a constant thickness, and a predetermined length. In the example shown in FIG. 2, the signal S flows from the front side to the back side in the signal line 1.

The first inner side line 2a is a linear band-shaped conductor. That is, the first inner side line 2a is a long plate-shaped conductor having a constant width, a constant thickness, and a predetermined length. The first inner side line 2a extends in the same direction as an extending direction of the signal line 1. The first inner side line 2a is provided in parallel with the signal line 1 and is spaced apart from one side (the right side in FIG. 1) of the signal line 1 by a predetermined distance M1.

The second inner side line 2b is a linear band-shaped conductor. That is, the second inner side line 2b is a long plate-shaped conductor having a constant width, a constant thickness, and a predetermined length, similarly to the first inner side line 2a. The second inner side line 2b extends in the same direction as the extending direction of the signal line 1. The second inner side line 2b is provided in parallel with the signal line 1 and is spaced apart from the other side (the left side in FIG. 1) of the signal line 1 by the predetermined distance M1.

The first outer side line 3a is a linear band-shaped conductor that is provided at a position farther from the signal line 1 than the first inner side line 2a on one side of the signal line 1. The first outer side line 3a is a long plate-shaped conductor having a constant width, a constant thickness, and a predetermined length. The first outer side line 3a is provided in parallel with the signal line 1 and separated by a predetermined distance from the signal line 1 in a state in which the first inner side line 2a is interposed therebetween. The first outer side line 3a extends in the same direction as the extending direction of the signal line 1, similarly to the first inner side line 2a and the second inner side line 2b.

The second outer side line 3b is a linear band-shaped conductor provided at a position farther from the signal line 1 than the second inner side line 2b on the other side of the signal line 1. The second outer side line 3b is a long plate-shaped conductor having a constant width, a constant thickness, and a predetermined length, similarly to the first outer side line 3a. The second outer side line 3b is provided in parallel with the signal line 1 and separated at a predetermined distance from the signal line 1 in a state in which the second inner side line 2b is interposed therebetween. The second outer side line 3b extends in the same direction as the extending direction of the signal line 1, similarly to the first inner side line 2a and the second inner side line 2b.

The first ground conductor 4a is a linear band-shaped conductor provided on the one end side of each of the first inner side line 2a, the second inner side line 2b, the first outer side line 3a, and the second outer side line 3b. The first ground conductor 4a is electrically connected to one end of each of the first inner side line 2a, the second inner side line 2b, the first outer side line 3a, and the second outer side line 3b. The first ground conductor 4a is a long plate-shaped conductor having a constant width, a constant thickness, and a predetermined length.

The first ground conductor 4a is provided to be orthogonal to the first inner side line 2a, the second inner side line 2b, the first outer side line 3a, and the second outer side line 3b extending in the same direction. The first ground conductor 4a is provided below and separated from the first inner side line 2a, the second inner side line 2b, the first outer side line 3a, and the second outer side line 3b at a predetermined distance.

One end of the first ground conductor 4a in the right to left direction is set to be substantially at the same position as the right side edge portion of the first outer side line 3a in the right to left direction. In addition, the other end of the first ground conductor 4a in the right to left direction is set to be substantially at the same position as the left side edge portion of the second outer side line 3b in the right to left direction.

The second ground conductor 4b is a linear band-shaped conductor provided on the side of the other end of each of the first inner side line 2a, the second inner side line 2b, the first outer side line 3a, and the second outer side line 3b. The second ground conductor 4b is a long plate-shaped conductor having a constant width, a constant thickness, and a predetermined length, similarly to the first ground conductor 4a.

The second ground conductor 4b is disposed in parallel with the first ground conductor 4a, and is provided to be perpendicular to the first inner side line 2a, the second inner side line 2b, the first outer side line 3a, and the second outer side line 3b, similarly to the first ground conductor 4a. The second ground conductor 4b is provided below and separated from the first inner side line 2a, the second inner side line 2b, the first outer side line 3a, and the second outer side line 3b at a predetermined distance.

One end of the second ground conductor 4b in the right to left direction is set to be substantially at the same position as the right side edge portion of the first outer side line 3a in the right to left direction. In addition, the other end of the second ground conductor 4b in the right to left direction is set to be substantially at the same position as the left side edge portion of the second outer side line 3b in the right to left direction. That is, the second ground conductor 4b has the same position as the first ground conductor 4a in the right to left direction.

The capacitor 5 is provided between the other end of the signal line 1 and the second ground conductor 4b. For example, in the capacitor 5, the upper electrode thereof is connected to the signal line 1, and the lower electrode thereof is electrically connected to the electronic switch 7d. For example, the capacitor 5 is a thin film capacitor having a metal insulator metal (MIM) structure. The capacitor 5 has a capacitance corresponding to a facing area of parallel plates. However, the comb-tooth type capacitor may be used for the capacitor 5 instead of the parallel plate type capacitor.

The plurality of connection conductors 6 include at least connection conductors 6a to 6f. The connection conductor 6a is a conductor that electrically and mechanically connects one end of the first inner side line 2a to the first ground conductor 4a. For example, the connection conductor 6a is a conductor extending in the up-down direction, one end (upper end) thereof is connected to the lower surface of one end of the first inner side line 2a, and the other end (lower end) thereof is connected to the top surface of the first ground conductor 4a.

The connection conductor 6b is a conductor that electrically and mechanically connects one end of the second inner side line 2b to the first ground conductor 4a. For example, the connection conductor 6b is a conductor extending in the up-down direction, similarly to the connection conductor 6a, one end (upper end) thereof is connected to the lower surface of one end of the second inner side line 2b, and the other end (lower end) thereof is connected to the top surface of the first ground conductor 4a.

The connection conductor 6c is a conductor that electrically and mechanically connects one end of the first outer side line 3a to the first ground conductor 4a. For example, the connection conductor 6c is a conductor extending in the up-down direction, one end (upper end) thereof is connected to the lower surface of one end of the first outer side line 3a, and the other end (lower end) thereof is connected to the top surface of the first ground conductor 4a.

The connection conductor 6d is a conductor that electrically and mechanically connects the other end of the first outer side line 3a to the second ground conductor 4b. For example, the connection conductor 6d is a conductor extending in the up-down direction, one end (upper end) thereof is connected to the lower surface of the other end of the first outer side line 3a, and the other end (lower end) thereof is connected to the top surface of the second ground conductor 4b.

The connection conductor 6e is a conductor that electrically and mechanically connects one end of the second outer side line 3b to the first ground conductor 4a. For example, the connection conductor 6e is a conductor extending in the up-down direction, one end (upper end) thereof is connected to the lower surface of one end of the second outer side line 3b, and the other end (lower end) thereof is connected to the top surface of the first ground conductor 4a.

The connection conductor 6f is a conductor that electrically and mechanically connects the other end of the second outer side line 3b to the second ground conductor 4b. For example, the connection conductor 6f is a conductor extending in the up-down direction, one end (upper end) thereof is connected to the lower surface of the other end of the second outer side line 3b, and the other end (lower end) thereof is connected to the top surface of the second ground conductor 4b.

The connection conductor 6g is a conductor that electrically and mechanically connects the other end of the signal line 1 to the upper electrode of the capacitor 5. For example, the connection conductor 6g is a conductor extending in the up-down direction, one end (upper end) thereof is connected to the lower surface of the other end of the signal line 1, and the other end (lower end) thereof is connected to the upper electrode of the capacitor 5.

The electronic switch 7a is connected between the other end of the first inner side line 2a and the second ground conductor 4b. The electronic switch 7a is, for example, a metal-oxide semiconductor field-effect transistor (MOSFET), the drain terminal thereof is electrically connected to the other end of the first inner side line 2a, the source terminal thereof is electrically connected to the second ground conductor 4b, and the gate terminal thereof is electrically connected to the switch control unit 8.

The electronic switch 7a is controlled to be in a closed state or an open state based on a gate signal input to the gate terminal from the switch control unit 8. The closed state is a state in which the drain terminal and the source terminal are in conduction. The open state is a state in which the drain terminal and the source terminal are not in conduction and the electrical connection is cut off. The electronic switch 7a is brought into a conduction state in which the other end of the first inner side line 2a is electrically connected to the second ground conductor 4b or a cut-off state in which the electrical connection is cut off, under the control of the switch control unit 8.

The electronic switch 7b is connected between the other end of the second inner side line 2b and the second ground conductor 4b. The electronic switch 7b is, for example, a MOSFET, the drain terminal thereof is connected to the other end of the second inner side line 2b, the source terminal thereof is connected to the second ground conductor 4b, and the gate terminal thereof is connected to the switch control unit 8.

The electronic switch 7b is controlled to be in the closed state or the open state based on a gate signal input to the gate terminal from the switch control unit 8. The electronic switch 7b is brought into a conduction state in which the other end of the second inner side line 2b is electrically connected to the second ground conductor 4b or a cut-off state in which the electrical connection is cut off, under the control of the switch control unit 8.

The electronic switch 7c is connected between the other end of the signal line 1 and the second ground conductor 4b. The electronic switch 7c is, for example, a MOSFET, the drain terminal thereof is connected to the other end of the signal line 1, the source terminal thereof is connected to the second ground conductor 4b, and the gate terminal thereof is connected to the switch control unit 8. In the example shown in FIG. 2, the electronic switch 7c is provided on the other end side of the signal line 1, but the present invention is not limited thereto, and the electronic switch 7c may be provided on the one end side of the signal line 1. The electronic switch 7c may not be used unless necessary.

The electronic switch 7c is controlled to be in the closed state or the open state based on a gate signal input to the gate terminal from the switch control unit 8. The electronic switch 7c is brought into a conduction state in which the other end of the signal line 1 is electrically connected to the second ground conductor 4b or a cut-off state in which the electrical connection is cut off, under the control of the switch control unit 8.

The electronic switch 7d is connected in series with the capacitor 5 between the other end of the signal line 1 and the second ground conductor 4b. The electronic switch 7d is, for example, a MOSFET. In the example shown in FIG. 2, in the electronic switch 7d, the drain terminal thereof is connected to the lower electrode of the capacitor 5, the source terminal thereof is connected to the second ground conductor 4b, and the gate terminal thereof is connected to the switch control unit 8.

The electronic switch 7d is controlled to be in the closed state or the open state based on a gate signal input to the gate terminal from the switch control unit 8. The electronic switch 7d is brought into a conduction state in which the lower electrode of the capacitor 5 and the second ground conductor 4b are electrically connected to each other or a state in which the electrical connection is cut off (i.e., a cut-off state), under the control of the switch control unit 8.

The switch control unit 8 is a control circuit that controls a plurality of electronic switches 7a, 7b, 7c, and 7d. For example, the switch control unit 8 includes four output ports. The switch control unit 8 outputs an individual gate signal from each output port and supplies the individual gate signal to each gate terminal of the plurality of electronic switches 7 and thus individually controls each of the plurality of electronic switches 7 to the open state or the closed state.

FIG. 2 shows a perspective view of the digital phase shift circuit 10 in order to easily understand the mechanical structure of the digital phase shift circuit 10, but the actual digital phase shift circuit 10 is formed as a multilayer structure by using semiconductor manufacturing technology.

For example, in the digital phase shift circuit 10, the signal line 1, the first inner side line 2a, the second inner side line 2b, the first outer side line 3a, and the second outer side line 3b are formed on a first conductive layer. The first ground conductor 4a and the second ground conductor 4b are formed in a second conductive layer facing the first conductive layer with an insulating layer interposed therebetween. The component formed in the first conductive layer and the component formed in the second conductive layer are connected to each other through a via hole. The plurality of connection conductors 6 correspond to via holes embedded in the insulating layer.

Next, an operation of the digital phase shift circuit 10 in the present embodiment will be described. The digital phase shift circuit 10 has a high delay mode and a low delay mode as operation modes. The digital phase shift circuit 10 operates in the high delay mode or the low delay mode.

### <<High Delay Mode>>

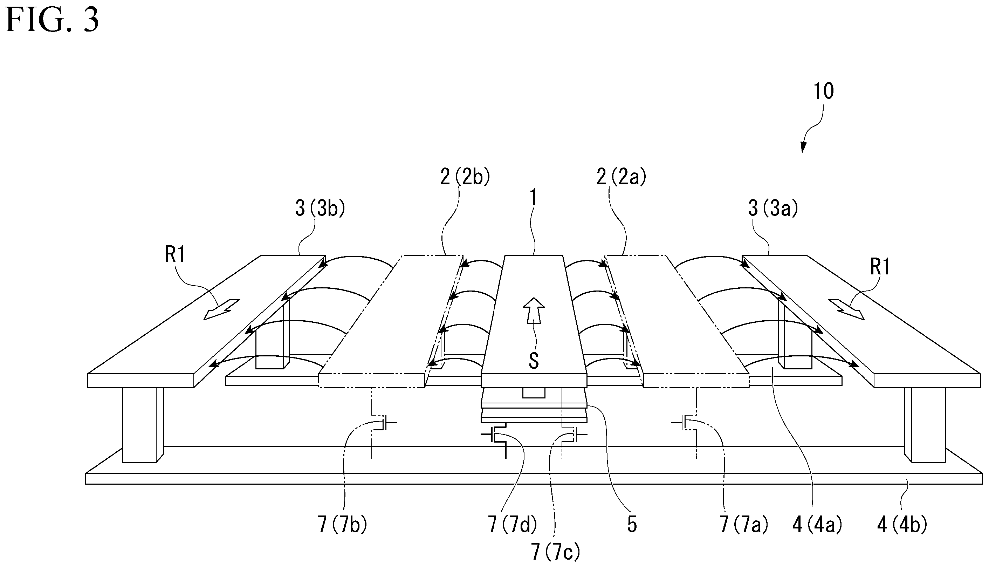

FIG. 3 is a diagram explaining the high delay mode of the digital phase shift circuit 10 according to the first embodiment. The high delay mode is a mode in which a first phase difference is generated in the signal S. In the high delay mode, as shown in FIG. 3, the electronic switch 7a and the electronic switch 7b are controlled to be in the open state, and the electronic switch 7d is controlled to be in the closed state.

The electronic switch 7a is controlled to be in the open state to cause a state in which an electrical connection between the other end of the first inner side line 2a and the second ground conductor 4b is cut off. The electronic switch 7b is controlled to be in the open state to cause a state in which an electrical connection between the other end of the second inner side line 2b and the second ground conductor 4b is cut off. By controlling the electronic switch 7d to be in the closed state, the other end of the signal line 1 is in a state of being connected to the second ground conductor 4b through the capacitor 5.

When the signal S propagates from the input end (the other end) to the output end (one end) of the signal line 1, a return current R1 flows from one end to the other end which is opposite to the direction of the signal S. In the high delay mode, since the electronic switch 7a and the electronic switch 7b are in the open state, the return current R1 mainly flows through the first outer side line 3a and the second outer side line 3b as shown in FIG. 3.

In the high delay mode, since the return current R1 flows through the first outer side line 3a and the second outer side line 3b, the inductance value is high compared with the low delay mode. In the high delay mode, a larger delay amount can be obtained compared with the low delay mode. In addition, when the electronic switch 7d is in the closed state, the other end of the signal line 1 and the second ground conductor 4b are electrically connected to each other by the capacitor 5, so that the capacitance value of the digital phase shift circuit 10 is also high. Therefore, in the high delay mode, a larger delay amount compared with the low delay mode can be obtained.

### <<Low Delay Mode>>

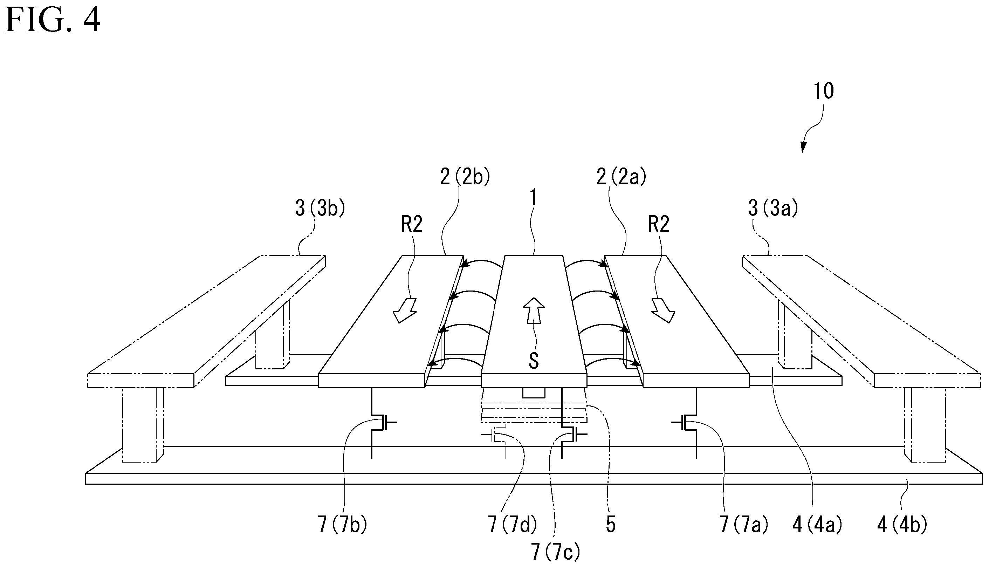

FIG. 4 is a diagram explaining a low delay mode of the digital phase shift circuit 10 according to the first embodiment. The low delay mode is a mode in which a second phase difference smaller than the first phase difference is generated in the signal S. In the low delay mode, as shown in FIG. 4, the electronic switch 7a and the electronic switch 7b are controlled to be in the closed state, and the electronic switch 7d is controlled to be in the open state.

The electronic switch 7a is controlled to be in the closed state to cause a state in which the other end of the first inner side line 2a and the second ground conductor 4b are electrically connected to each other. The electronic switch 7b is controlled to be in the closed state to cause a state in which the other end of the second inner side line 2b and the second ground conductor 4b are electrically connected to each other.

When the signal S propagates from the input end (the other end) to the output end (one end) of the signal line 1, a return current R2 flows from one end, which is opposite to the direction of the signal S, to the other end. In the low delay mode, since the electronic switch 7a and the electronic switch 7b are in the closed state, the return current R2 mainly flows through the first inner side line 2a and the second inner side line 2b as shown in FIG. 4.

In the low delay mode, since the return current R2 flows through the first inner side line 2a and the second inner side line 2b, the inductance value is lower compared with the high delay mode. The delay amount in the low delay mode is smaller than the delay amount in the high delay mode. In addition, although the capacitor 5 is connected to the other end of the signal line 1, the electronic switch 7d is in the open state, so that the capacitance of the capacitor 5 does not function (is not visible from the signal line 1), and only a parasitic capacitance that is extremely small compared with the capacitance of the capacitor 5 is present. Therefore, in the low delay mode, a smaller delay amount compared with the high delay mode can be obtained.

In the low delay mode, it is also possible to intentionally increase the loss of the signal line 1 by controlling the electronic switch 7c to be in the closed state. The above-mentioned is to make the loss of the high-frequency signal in the low delay mode the same as the loss of the high-frequency signal in the high delay mode.

That is, the loss of the high-frequency signal in the low delay mode is clearly smaller than the loss of the high-frequency signal in the high delay mode. The loss difference causes an amplitude difference of the high-frequency signal output from the digital phase shift circuit 10 when the operation mode is switched between the low delay mode and the high delay mode. In response to such circumstances, the digital phase shift circuit 10 may eliminate the amplitude difference by controlling the electronic switch 7c to be in the closed state in the low delay mode.

### <Connection Portion>

The connection portion 20 has a phase shift amount adjustment function. As described below, since the connection portion 20 has a function of adjusting the phase shift amount in the same manner as the digital phase shift circuit 10, the connection portion 20-1 may be referred to as a relay digital phase shift circuit 10-41 below. In addition, the connection portion 20-2 may be referred to as a relay digital phase shift circuit 10-42, and the connection portion 20-3 may be referred to as a relay digital phase shift circuit 10-43.

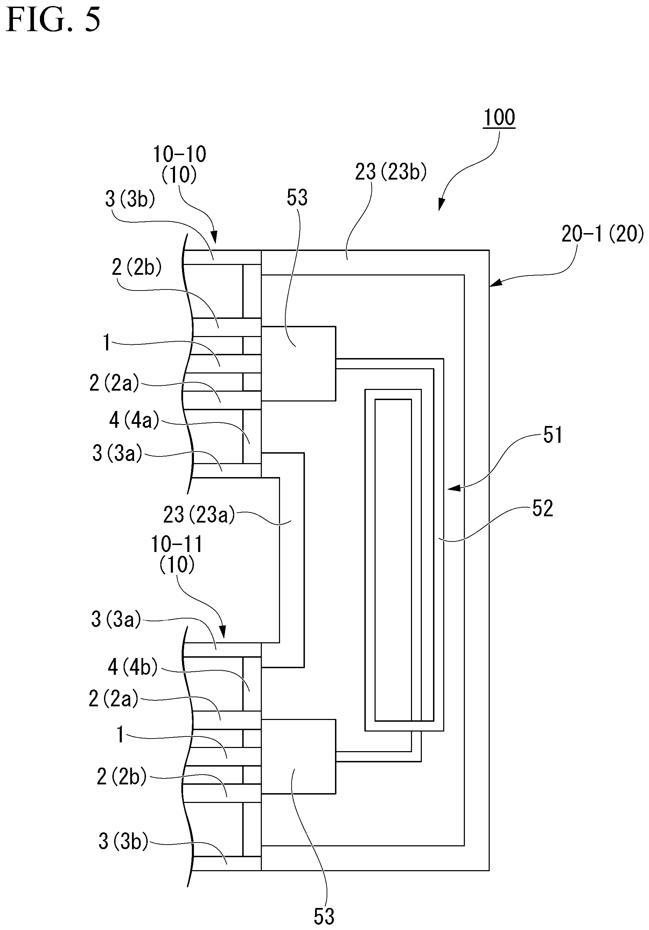

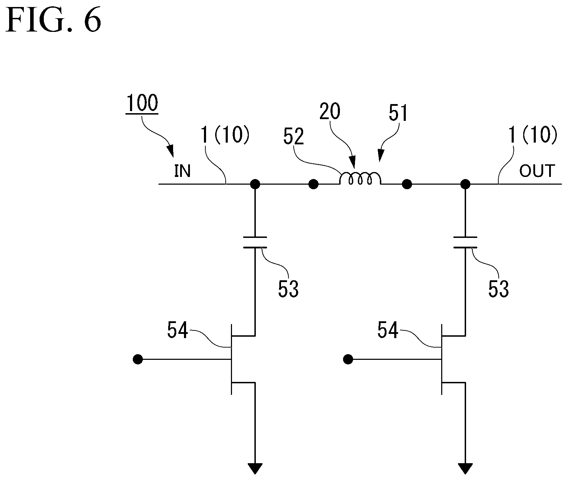

FIG. 5 is a plan view showing the connection portion 20 according to the first embodiment. FIG. 6 is a circuit diagram showing the connection portion 20 according to the first embodiment. The digital phase shifter 100 of the present embodiment includes the three connection portions 20 (the connection portions 20-1, 20-2, and 20-3), but since the three connection portions 20 have the same configuration, the connection portion 20-1 will be described here. As shown in FIGS. 5 and 6, the connection portion 20-1 includes a connection line 23 and a first connection circuit 51. In the present embodiment, the three connection portions 20 (the connection portions 20-1, 20-2, and 20-3) are provided, but it is sufficient that there is one or more connection portions 20 having a phase shift amount adjustment function.

As shown in FIG. 5, the connection line 23 connects the outer side line 3 of the digital phase shift circuit 10-10 to the outer side line 3 of the digital phase shift circuit 10-11. The connection line 23 includes a first connection line 23a of which one end is connected to the first outer side line 3a of the digital phase shift circuit 10-10 and the other end is connected to the first outer side line 3a of the digital phase shift circuit 10-11. The first outer side line 3a is electrically connected to the first inner side line 2a through the ground conductor 4 described above.

The first connection line 23a is a long plate-shaped conductor having a constant width, a constant thickness, and a predetermined length. It is desirable that the first connection line 23a has a width larger than the first outer side line 3a.

In addition, the connection line 23 includes a second connection line 23b of which one end is connected to the second outer side line 3b of the digital phase shift circuit 10-10 and the other end is connected to the second outer side line 3b of the digital phase shift circuit 10-11. The second outer side line 3b is electrically connected to the second inner side line 2b through the ground conductor 4 described above. The second connection line 23b is provided in parallel with the first connection line 23a, separated by a predetermined distance. The second connection line 23b is a long plate-shaped conductor having a constant width, a constant thickness, and a predetermined length. The second connection line 23b preferably have a width larger than the second outer side line 3b.

In the example shown in FIG. 5, the connection line 23 is connected to the outer side line 3 in the same layer, but the connection line 23 may be connected to the outer side line 3 in a different layer through a via. That is, the first connection line 23a may be electrically connected to the first outer side line 3a, and the second connection line 23b may be electrically connected to the second outer side line 3b.

The first connection circuit 51 connects the signal line 1 of the digital phase shift circuit 10-10 to the signal line 1 of the digital phase shift circuit 10-11. The first connection circuit 51 adjusts the phase shift amount in the connection portion 20. The first connection circuit 51 in the first embodiment constitutes a π-type circuit shown in FIG. 6. The first connection circuit 51 includes a coil 52, a capacitor 53, and an electronic switch 54.

The coil 52 is connected in series between the signal line 1 of the digital phase shift circuit 10-10 and the signal line 1 of the digital phase shift circuit 10-11. As the coil 52, for example, a spiral inductor is preferable. The spiral inductor spans almost the entire section of the connection portion 20. As the coil 52, a winding coil, a laminated coil, a thin film coil, or the like other than the spiral inductor may be used.

The capacitor 53 is connected in parallel to both sides of the coil 52. As the capacitor 53, for example, a thin film capacitor having a metal insulator metal (MIM) structure can be used. The capacitor 53 has a capacitance corresponding to a facing area of parallel plates. However, the comb-tooth type capacitor may be used for the capacitor 53 instead of the parallel plate type capacitor. The capacitances of a pair of capacitors 53 are equal to each other.

In the capacitor 53, the upper electrode thereof is connected to an end portion of the coil 52, and the lower electrode thereof is electrically grounded. The lower electrode of the capacitor 53 may be connected to any of the connection line 23 disposed nearby, the inner side line 2, the outer side line 3, and the ground conductor 4 of the digital phase shift circuit 10, or other grounds (a frame ground of the digital phase shifter 100 (not shown), or the like).

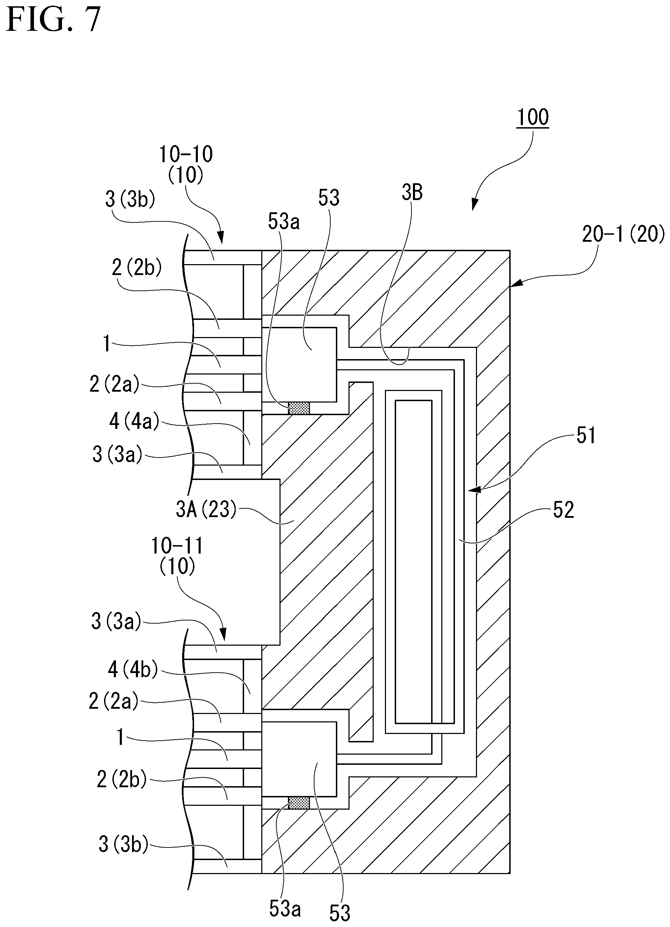

FIG. 7 is a plan view showing a modification example of the connection portion 20 according to the first embodiment. As shown in FIG. 7, a lower electrode 53a of the capacitor 53 may be connected to the ground layer 3A elongating from the first ground conductor 4a of the digital phase shift circuit 10-10 to the second ground conductor 4b of the digital phase shift circuit 10-11.

In the modification example, the first ground conductor 4a and the second ground conductor 4b are configured with a multilayer. In the ground layer 3A, one layer of the ground conductor that is a multilayer elongates to form the connection line 23 that connects the outer side line 3 of the digital phase shift circuit 10-10 to the outer side line 3 of the digital phase shift circuit 10-11. A portion (metal) of the ground layer 3A overlapping the coil 52 and the capacitor 53 is removed to produce a cutout portion 3B.

In the configuration, the capacitor 53 is disposed in the cutout portion 3B, and the lower electrode 53a is connected to the ground layer 3A. The lower electrode 53a of the capacitor 53 may be connected to any one of the inner side line 2, the outer side line 3, and the ground conductor 4 of the digital phase shift circuit 10 disposed nearby.

Returning to FIG. 6, the electronic switch 54 is provided on each of the lower electrode sides of the pair of capacitors 53 and switches whether or not to ground the lower electrode side of the pair of capacitors 53. The electronic switch 54 may be provided on the upper electrode side of the capacitor 53. The electronic switch 54 is connected in series to the capacitor 53 between the lower electrode of the capacitor 53 and the ground. The electronic switch 54 is, for example, a MOSFET.

In the electronic switch 54, the drain terminal thereof is connected to the lower electrode of the capacitor 53, the source terminal thereof is connected to ground, and the gate terminal thereof is connected to a switch control unit (not shown). The switch control unit of the electronic switch 54 may be a control device independent of the switch control unit 8 of the digital phase shift circuit 10 shown in FIG. 2 described above, or may be a common control device.

The electronic switch 54 is controlled to be in the closed state or the open state based on a gate signal input to the gate terminal from the switch control unit. The electronic switch 54 is controlled by the switch control unit to be in a conduction state in which the lower electrode of the capacitor 53 and the ground are electrically connected to each other or a cut-off state in which the electrical connection is cut off. The electronic switch 54 may be a bipolar transistor (BJT) or the like.

When the electronic switch 54 is in the closed state, the capacitor 53 and the ground are electrically connected to each other, and the capacitance of the connection portion 20 is increased. As a result, a larger delay amount than when the electronic switch 54 is in the open state can be obtained (high delay mode). In addition, when the electronic switch 54 is in the open state, the series composite capacitance of the capacitor 53 and the parasitic capacitance of the electronic switch 54 in the open state functions, and a smaller delay amount than when the electronic switch 54 is in the closed state can be obtained (low delay mode). Due to the low delay mode, the electronic switch 54 is an electronic switch having a parasitic capacitance and is preferably the above-mentioned FET or BJT.

### <Characteristics of Digital Phase Shifter>

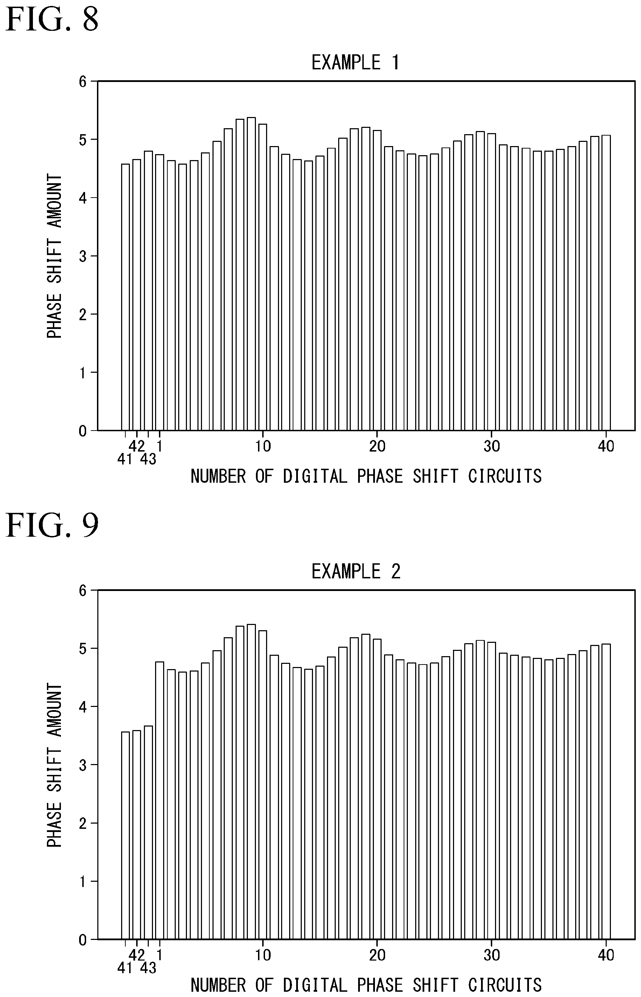

FIG. 8 is a diagram showing a distribution of a phase shift amount of Example 1 of the digital phase shifter 100 according to the first embodiment. In the graph shown in FIG. 8, the horizontal axis indicates the numbers of the digital phase shift circuits 10, and the vertical axis indicates the phase shift amount of each of the digital phase shift circuits 10. In FIG. 8, although it is irregular, the phase shift amounts of the connection portion 20 (the relay digital phase shift circuits 10-41 to 10-43) are shown prior to the digital phase shift circuits 10-1 to 10-40 on the horizontal axis. FIG. 8 shows the distribution of the phase shift amount when the electronic switch 54 is switched from the open state to the closed state in the order of the relay digital phase shift circuits 10-41 to 10-43.

Specifically, FIG. 8 shows a phase shift amount distribution obtained when switching control to the low delay mode is sequentially performed in the order of the relay digital phase shift circuits 10-41 to 10-43 and the digital phase shift circuits 10-1 to 10-40 from a state in which all the relay digital phase shift circuits 10-41 to 10-43 and the digital phase shift circuits 10-1 to 10-40 are set in the high delay mode. In addition, FIG. 8 shows a phase shift amount distribution when the frequency of the signal S is 30 GHz, the inductance of the coil 52 is 25.74 pH, and the capacitance of the capacitor 53 is 42 fF. The ideal characteristic of the digital phase shifter 100 is that the upper portion of the graph shown in FIG. 8 is flat (there is no distribution of the phase shift amount).

Referring to FIG. 8, it can be seen that when the capacitance of the capacitor 53 is set to 42 fF, the phase shift amount of the connection portion 20 (the relay digital phase shift circuits 10-41 to 10-43) is the same as those of the digital phase shift circuits 10-1 to 10-40. Therefore, in this case, a total of 43 units including the connection portion 20 (the relay digital phase shift circuits 10-41 to 10-43) can be used as the phase shift circuits, and the connection portion 20 (the relay digital phase shift circuits 10-41 to 10-43) can be used as an adjustment unit after the digital phase shift circuits 10-1 to 10-40 are normally used.

FIG. 9 is a diagram showing a distribution of a phase shift amount of Example 2 of the digital phase shifter 100 according to the first embodiment. In Example 2, the capacitance of the capacitor 53 is 35 fF. Other conditions are the same as those in FIG. 8.

Referring to FIG. 9, it can be seen that when the capacitance of the capacitor 53 is set to 35 fF, the phase shift amount of the connection portion 20 (the relay digital phase shift circuits 10-41 to 10-43) is smaller than the phase shift amounts of the digital phase shift circuits 10-1 to 10-40. Accordingly, the electronic switch 54 is set to the closed state as necessary, so that the connection portion 20 (the relay digital phase shift circuits 10-41 to 10-43) can be used as an adjustment unit that reduces the phase shift amount.

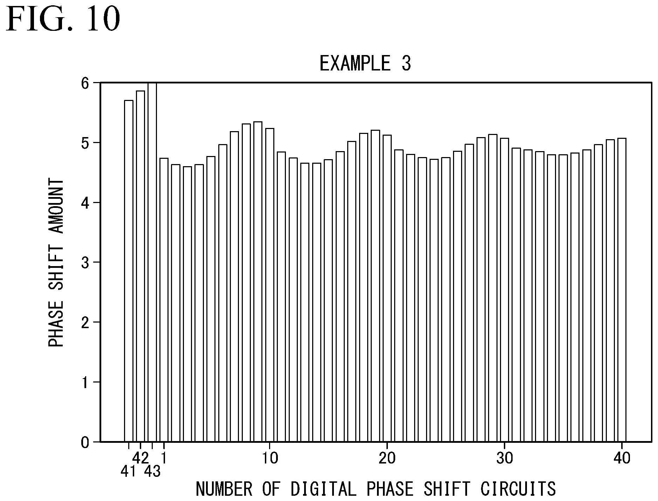

FIG. 10 is a diagram showing a distribution of a phase shift amount of Example 3 of the digital phase shifter 100 according to the first embodiment. In Example 3, the capacitance of the capacitor 53 is 50 fF. Other conditions are the same as those in FIG. 8.

Referring to FIG. 10, it can be seen that when the capacitance of the capacitor 53 is 50 fF, the phase shift amount of the connection portions 20 (the relay digital phase shift circuits 10-41 to 10-43) is larger than the phase shift amounts of the digital phase shift circuits 10-1 to 10-40. Therefore, in this case, the electronic switch 54 is set to the closed state as necessary, so that the connection portion 20 (the relay digital phase shift circuits 10-41 to 10-43) can be used as an adjustment unit that increases the phase shift amount.

The convex portion and the concave portion of the phase shift amounts shown in FIGS. 8 to 10 can be relaxed by applying a relaxation circuit of a fifth embodiment described later.

Furthermore, when a transmission line is configured on an integrated circuit (IC), there is a problem in that, since the design thereof is restricted by various design rules, it is difficult to realize a transmission line having a low characteristic impedance or a transmission line having a high characteristic impedance or to realize high-accuracy impedance control. However, in order to transmit a relatively long-distance signal, it is necessary to use the transmission line configured on the IC while it is restricted by various design rules. On the other hand, since the bend type connection portion 20 (folded portion) corresponds to signal transmission at a relatively short distance, the circuit impedance can be strictly designed and realized by the coil 52 or the capacitor 53 when the first connection circuit 51 is used. That is, the circuit impedance is strictly determined by the inductance of the coil 52 and the capacitance of the capacitor 53, not by the design rule of the IC. In addition, the shape, configuration (a bending method, a size, or the like), and value of the coil 52 have a certain degree of freedom, and thus are optimal for connection at a relatively short distance.

It should be noted that, instead of the first connection circuit 51, it is also conceivable to mount the same circuit as the digital phase shift circuit 10 on the connection portion 20, but in this configuration, while he connection portion 20 has a phase shifting function, there is a problem in that the size of the connection portion 20 is increased due to a restriction by the total length of the digital phase shift circuit 10. This is based on the idea of functional separation in which the bend function is carried out by the connection portion 20 and the phase shifting function is carried out by the digital phase shift circuit 10. Therefore, in the present embodiment, the coil 52, the capacitor 53, and the electronic switch 54 are provided in the connection portion 20, and the bend function and the phase shift (adjustment) function are integrated. As a result, the phase shift amount can be adjusted without increasing the size of the connection portion 20. That is, when the connection portion 20 does not exhibit the phase shifting function, the electronic switch 54 is set in the open state, so that the digital phase shifter 100 becomes a phase shift circuit of 40 units. In addition, when the connection portion 20 exhibits the phase shifting function, the electronic switch 54 is set in the closed state, so that the digital phase shifter 100 becomes a phase shift circuit of 43 units.

As described above, the digital phase shifter 100 of the present embodiment includes the plurality of digital phase shift circuit groups 30 in which the plurality of digital phase shift circuits 10 are connected in cascade, and the one or more bend type connection portions 20 that connect two digital phase shift circuit groups 30 to each other, in which the digital phase shift circuit 10 includes at least the signal line 1, the pair of inner side lines 2 that are provided on both sides of the signal line 1, the pair of outer side lines 3 that are provided outside of the pair of inner side lines 2, the first ground conductor 4a that is connected to one end of each of the pair of inner side lines 2 and the pair of outer side lines 3, the second ground conductor 4b that is connected to the other end of each of the pair of outer side lines 3, and the pair of electronic switches 7a and 7b (first electronic switches) that are each provided between the other end of each of the pair of inner side lines 2 and the second ground conductor 4b, and is a circuit that is set to a low delay mode in which a return current flows through the pair of inner side lines 2 or a high delay mode in which a return current flows through the pair of outer side lines 3, the connection portion 20 includes the first connection circuit 51 that connects the signal line 1 of the first digital phase shift circuit 10 to the signal line 1 of the second digital phase shift circuit 10, of two digital phase shift circuit 10, and the connection line 23 that electrically connects the pair of outer side lines 3 of the first digital phase shift circuit 10 to the pair of outer side lines 3 of the second digital phase shift circuit 10, and the first connection circuit 51 includes the coil 52 (first coil) that is connected in series between the signal line 1 of the first digital phase shift circuit 10 and the signal line 1 of the second digital phase shift circuit 10, the pair of capacitors 53 (first capacitor) that are connected in parallel to both sides of the coil 52, and the pair of electronic switches 54 (second electronic switches) that are each provided on one end side of the pair of capacitors 53 and switch between whether or not to ground the one end side of the pair of capacitors 53. According to the configuration, the phase shift amount can be adjusted in the connection portion 20.

In the present embodiment, the phase shift amount is adjusted in two patterns in which each of the pair of electronic switches 54 is in the open state or the closed state, but the phase shift amount may be adjusted in three patterns in which one switch of the pair of electronic switches 54 is in the open state and the other switch is in the closed state.

### (Second Embodiment)

Next, a second embodiment of the present invention will be described. In the following description, the same or equivalent configurations as those in the above-described embodiment are denoted by the same reference numerals, and descriptions thereof will be simplified or omitted.

### <Digital Phase Shifter>

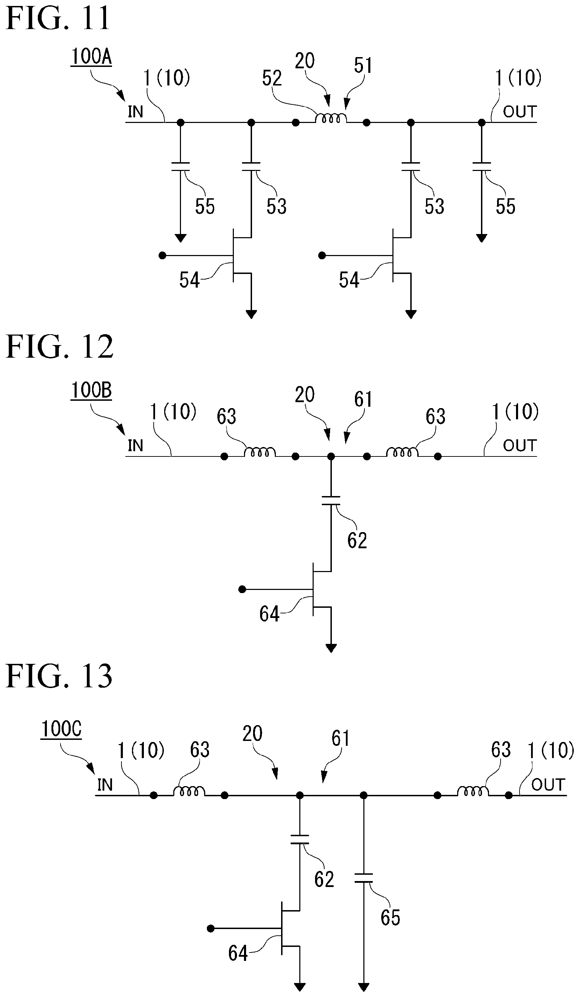

FIG. 11 is a circuit diagram showing the connection portion 20 of a digital phase shifter 100A according to the second embodiment. As shown in FIG. 11, the second embodiment is different from the first embodiment in that the connection portion 20 further includes a pair of capacitors 55.

The pair of capacitors 55 are connected in parallel on both sides (an IN side and an OUT side) of the pair of capacitors 53. In the capacitor 55, for example, the upper electrode thereof is connected to a contact point between the signal line 1 and the coil 52, and the lower electrode thereof is electrically grounded. The electronic switch 54 is not provided on the lower electrode side of the capacitor 55 as in the lower electrode side of the capacitor 53. The capacitance of the capacitor 55 may be equal to or different from that of the capacitor 53. The capacitances of the pair of capacitors 55 are equal to each other.

As described above, in the digital phase shifter 100A of the second embodiment, the connection portion 20 includes the pair of capacitors 55 (second capacitors) connected in parallel on both sides of the pair of capacitors 53. According to the configuration, the connection portion 20 can be integrated with the bend function and the phase shift (adjustment) function, and can always function as the phase shift adjustment circuit. As a result, it is possible to average a distribution of a phase shift amount generated due to weak reflection generated before and after the connection portion 20.

### (Third Embodiment)

Next, a third embodiment of the present invention will be described. In the following description, the same or equivalent configurations as those in the above-described embodiment are denoted by the same reference numerals, and descriptions thereof will be simplified or omitted.

### <Digital Phase Shifter>

FIG. 12 is a circuit diagram showing the connection portion 20 of a digital phase shifter 100B according to the third embodiment. As shown in FIG. 12, the third embodiment is different from the first and second embodiments in that the connection portion 20 includes a second connection circuit 61 (T-type circuit) that can strictly determine the circuit impedance, similarly to the first connection circuit (π-type circuit) described above.

The second connection circuit 61 includes a capacitor 62, a pair of coils 63, and an electronic switch 64. The capacitor 62 is connected in parallel between the pair of coils 63. In the capacitor 62, the upper electrode thereof is connected between the pair of coils 63, and the lower electrode thereof is electrically grounded. The coil 63 is provided in a pair on both sides (the IN side and the OUT side) of the capacitor 62 and is connected in series between the signal lines 1 of two digital phase shift circuits 10. As the coil 63, for example, a spiral inductor is preferable. The inductances of the pair of coils 63 are equal to each other.

The electronic switch 64 is provided on one end side of the capacitor 62. The electronic switch 64 switches whether or not to ground one end side of the capacitor 62. In the example shown in FIG. 12, the electronic switch 64 is provided on the lower electrode side of the capacitor 62. The electronic switch 64 may be provided on the upper electrode side of the capacitor 62. The electronic switch 64 is connected in series to the capacitor 62 between the lower electrode of the capacitor 62 and the ground. The electronic switch 64 is, for example, a MOSFET.

In the electronic switch 64, the drain terminal thereof is connected to the lower electrode of the capacitor 62, the source terminal thereof is connected to ground, and the gate terminal thereof is connected to a switch control unit (not shown). The electronic switch 64 is controlled to be in the closed state or the open state based on a gate signal input to the gate terminal from the switch control unit. The electronic switch 64 is controlled by the switch control unit to be in a conduction state in which the lower electrode of the capacitor 62 and the ground are electrically connected to each other or a cut-off state in which the electrical connection is cut off. The electronic switch 64 may be a bipolar transistor (BJT) or the like.

When the electronic switch 64 is in the closed state, the capacitor 62 and the ground are electrically connected to each other, and the capacitance of the connection portion 20 is increased. As a result, a larger delay amount than when the electronic switch 64 is in the open state can be obtained (high delay mode). In addition, when the electronic switch 64 is in the open state, the series composite capacitance of the capacitor 62 and the parasitic capacitance of the electronic switch 64 in the open state functions, and a smaller delay amount than when the electronic switch 64 is in the closed state can be obtained (low delay mode). Due to the low delay mode, the electronic switch 64 is an electronic switch having a parasitic capacitance and is preferably the above-mentioned FET or BJT.

As described above, in the digital phase shifter 100B of the third embodiment, the connection portion 20 includes the capacitor 62 (third capacitor) that is connected in parallel between the signal lines 1 of two digital phase shift circuits 10, the pair of coils 63 (second coils) that are connected in series on both sides of the capacitor 62, and the pair of electronic switches 64 (third electronic switches) that are provided on one end side of the capacitor 62 and switch whether or not to ground the one end side of the capacitor 62. According to the configuration, as in the first embodiment, the phase shift amount can be adjusted in the connection portion 20.

### (Fourth Embodiment)

Next, a fourth embodiment of the present invention will be described. In the following description, the same or equivalent configurations as those in the above-described embodiment are denoted by the same reference numerals, and descriptions thereof will be simplified or omitted.

### <Digital Phase Shifter>

FIG. 13 is a circuit diagram showing the connection portion 20 of a digital phase shifter 100C according to the fourth embodiment. As shown in FIG. 13, the fourth embodiment is different from the third embodiment in that the connection portion 20 further includes a capacitor 65.

The capacitor 65 is connected in parallel between the pair of coils 63. In the capacitor 65, the upper electrode thereof is connected between the pair of coils 63, and the lower electrode thereof is electrically grounded. The upper electrode of the capacitor 65 may be connected to either the IN side or the OUT side of the capacitor 62. The electronic switch 64 is not provided on the lower electrode side of the capacitor 65 as in the lower electrode side of the capacitor 62. The capacitance of the capacitor 65 may be equal to or different from that of the capacitor 62.

As described above, in the digital phase shifter 100C of the fourth embodiment, the connection portion 20 includes the capacitor 65 (fourth capacitor) connected in parallel between the pair of coils 63. According to the configuration, the connection portion 20 can be integrated with the bend function and the phase shift (adjustment) function, and can always function as the phase shift adjustment circuit. As a result, it is possible to average the distribution of the phase shift amount generated due to the weak reflection generated before and after the connection portion 20.

### (Fifth Embodiment)

Next, a fifth embodiment of the present invention will be described. In the following description, the same or equivalent configurations as those in the above-described embodiment are denoted by the same reference numerals, and descriptions thereof will be simplified or omitted.

In the fifth embodiment, in order to relax the convex portion or the concave portion of the distribution of the phase shift amount, at least one of the digital phase shift circuits 10-1 to 10-40 described above is set to be a relaxation circuit that relaxes the distribution of the phase shift amount generated due to the weak reflection generated before and after the connection portion 20.

The relaxation circuit includes a first relaxation circuit RC1 and a second relaxation circuit RC2, as will be described later. The first relaxation circuit RC1 is the digital phase shift circuit 10 that has a larger phase shift amount compared with the digital phase shift circuit 10 other than the relaxation circuit (the first relaxation circuit RC1 and the second relaxation circuit RC2) and is a circuit that relaxes the concave portion of the distribution of the phase shift amount. The second relaxation circuit RC2 is the digital phase shift circuit 10 that has a smaller phase shift amount compared with the digital phase shift circuit 10 other than the relaxation circuit (the first relaxation circuit RC1 and the second relaxation circuit RC2) and is a circuit that relaxes the convex portion of the distribution of the phase shift amount.

For example, in the case of FIG. 8, the digital phase shift circuits 10-7 to 10-10 may be the second relaxation circuit RC2. In addition, the digital phase shift circuits 10-13 to 10-15 may be the first relaxation circuit RC1. The specific configuration of the relaxation circuit (the first relaxation circuit RC1 and the second relaxation circuit RC2) will be described later.

### <Relaxation Circuit>

### <<First Relaxation Circuit>>

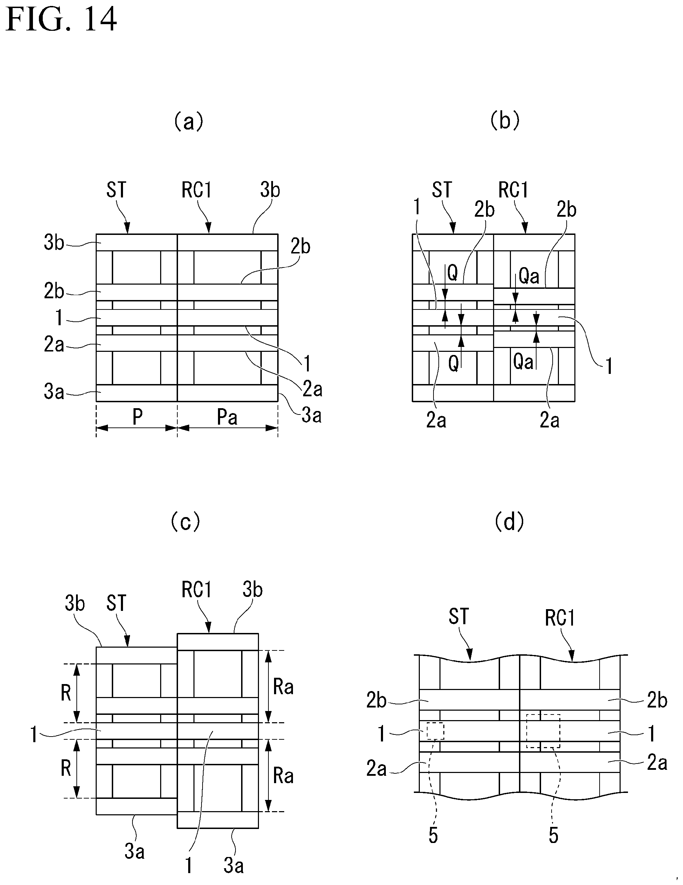

FIG. 14 is a diagram explaining the first relaxation circuit RC1 of the relaxation circuit according to the fifth embodiment. The basic configuration of the first relaxation circuit RC1 is substantially the same as that of the digital phase shift circuit 10 (hereinafter, referred to as a "standard digital phase shift circuit ST") other than the relaxation circuit (the first relaxation circuit RC1 and the second relaxation circuit RC2). However, the first relaxation circuit RC1 has a configuration slightly different from that of the standard digital phase shift circuit ST such that the first relaxation circuit RC1 has a larger phase shift amount compared with the standard digital phase shift circuit ST.

Specifically, the first relaxation circuit RC1 is configured to satisfy at least one of the following conditions.
· Condition 1: The length is longer than that of the standard digital phase shift circuit ST.
· Condition 2: The distance between the signal line 1 and the inner side line 2 is shorter than that of the standard digital phase shift circuit ST.
· Condition 3: The distance between the signal line 1 and the outer side line 3 is longer than that of the standard digital phase shift circuit ST.
· Condition 4: The capacitor 5 is larger than that of the standard digital phase shift circuit ST.
· Condition 5: The electronic switches 7a and 7b are larger than those of the standard digital phase shift circuit ST.

Part (a) of FIG. 14 is a diagram showing the first relaxation circuit RC1 satisfying the above-described "Condition 1". In the first relaxation circuit RC1 shown in the part (a) of FIG. 14, a length (the length of the signal line 1, the inner side line 2, the outer side line 3, or the like) Pa is longer than a length P of the standard digital phase shift circuit ST.

Part (b) of FIG. 14 is a diagram showing the first relaxation circuit RC1 satisfying the above-described "Condition 2". In the first relaxation circuit RC1 shown in the part (b) of FIG. 14, a distance Qa between the signal line 1 and the inner side line 2 (the first inner side line 2a and the second inner side line 2b) is shorter than a distance Q between the signal line 1 and the inner side line 2 (the first inner side line 2a and the second inner side line 2b) in the standard digital phase shift circuit ST.

Part (c) of FIG. 14 is a diagram showing the first relaxation circuit RC1 satisfying the above-described "Condition 3". In the first relaxation circuit RC1 shown in the part (c) of FIG. 14, a distance Ra between the signal line 1 and the outer side line 3 (the first outer side line 3a and the second outer side line 3b) is longer than a distance R between the signal line 1 and the outer side line 3 (the first outer side line 3a and the second outer side line 3b) in the standard digital phase shift circuit ST.

Part (d) of FIG. 14 is a diagram showing the first relaxation circuit RC1 satisfying the above-described "Condition 4". In the first relaxation circuit RC1 shown in the part (d) of FIG. 14, the size of the capacitor 5 is larger than the size of the capacitor 5 in the standard digital phase shift circuit ST. Although not shown, in the first relaxation circuit RC1 satisfying the above-described "Condition 5", the sizes of the electronic switch 7a and the electronic switch 7b (refer to FIGS. 2 to 4) are larger than the sizes of the electronic switch 7a and the electronic switch 7b of the standard digital phase shift circuit ST.

As described above, the first relaxation circuit RC1 has a larger phase shift amount compared with the standard digital phase shift circuit ST. Therefore, by using the first relaxation circuit RC1 instead of the standard digital phase shift circuit ST, the phase shift amount can be increased. Therefore, for example, when the distribution of the phase shift amount generated due to the weak reflection generated before and after the connection portion 20 has a concave portion, the concave portion can be relaxed by using the first relaxation circuit RC1.

### <<Second Relaxation Circuit>>

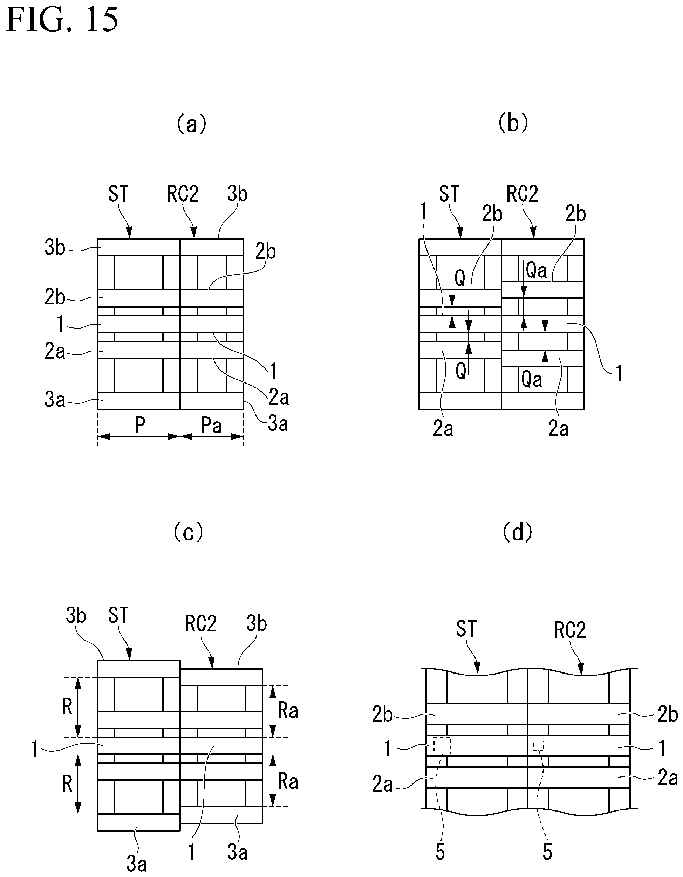

FIG. 15 is a diagram explaining the second relaxation circuit RC2 of the relaxation circuit according to the fifth embodiment. The basic configuration of the second relaxation circuit RC2 is substantially the same as that of the standard digital phase shift circuit ST, as in the first relaxation circuit RC1. However, the second relaxation circuit RC2 has a configuration slightly different from the standard digital phase shift circuit ST such that the phase shift amount is smaller compared with the standard digital phase shift circuit ST.

Specifically, the second relaxation circuit RC2 is configured to satisfy at least one of the following conditions.
· Condition 1: The length is shorter than that of the standard digital phase shift circuit ST.
· Condition 2: The distance between the signal line 1 and the inner side line 2 is longer than that of the standard digital phase shift circuit ST.
· Condition 3: The distance between the signal line 1 and the outer side line 3 is shorter than that of the standard digital phase shift circuit ST.
· Condition 4: The capacitor 5 is smaller than that of the standard digital phase shift circuit ST.
· Condition 5: The electronic switches 7a and 7b are smaller than those of the standard digital phase shift circuit ST.

Part (a) of FIG. 15 is a diagram showing the second relaxation circuit RC2 satisfying the above-described "Condition 1". In the second relaxation circuit RC2 shown in the part (a) of FIG. 15, the length (the length of the signal line 1, the inner side line 2, the outer side line 3, or the like) Pa is shorter than the length P of the standard digital phase shift circuit ST.

Part (b) of FIG. 15 is a diagram showing the second relaxation circuit RC2 satisfying the above-described "Condition 2". In the second relaxation circuit RC2 shown in the part (b) of FIG. 15, the distance Qa between the signal line 1 and the inner side line 2 (the first inner side line 2a and the second inner side line 2b) is longer than the distance Q between the signal line 1 and the inner side line 2 (the first inner side line 2a and the second inner side line 2b) in the standard digital phase shift circuit ST.

Part (c) of FIG. 15 is a diagram showing the second relaxation circuit RC2 satisfying the above-described "Condition 3". In the second relaxation circuit RC2 shown in the part (c) of FIG. 15, the distance Ra between the signal line 1 and the outer side line 3 (the first outer side line 3a and the second outer side line 3b) is shorter than the distance R between the signal line 1 and the outer side line 3 (the first outer side line 3a and the second outer side line 3b) in the standard digital phase shift circuit ST.

Part (d) of FIG. 15 is a diagram showing the second relaxation circuit RC2 satisfying the above-described "Condition 4". In the second relaxation circuit RC2 shown in the part (d) of FIG. 15, the size of the capacitor 5 is smaller than the size of the capacitor 5 in the standard digital phase shift circuit ST. Although not shown, in the second relaxation circuit RC2 satisfying the above-described "Condition 5", the sizes of the electronic switch 7a and the electronic switch 7b (refer to FIGS. 2 to 4) are smaller than the sizes of the electronic switch 7a and the electronic switch 7b of the standard digital phase shift circuit ST.

As described above, the second relaxation circuit RC2 has a smaller phase shift amount compared with the standard digital phase shift circuit ST. Therefore, by using the second relaxation circuit RC2 instead of the standard digital phase shift circuit ST, the phase shift amount can be decreased. Therefore, for example, when the distribution of the phase shift amount generated due to the weak reflection generated before and after the connection portion 20 has a convex portion, the convex portion can be relaxed by using the second relaxation circuit RC2.

As described above, in the fifth embodiment, the plurality of digital phase shift circuit groups 30 in which the plurality of digital phase shift circuits 10 are connected in cascade, and the one or more bend type connection portions 20 that connect two digital phase shift circuit groups 30 to each other are provided, and at least one of the digital phase shift circuits 10 constituting the at least one digital phase shift circuit group 30 is the relaxation circuit that relaxes the distribution of the phase shift amount. Therefore, it is possible to further relax the distribution of the phase shift amount generated due to the weak reflection generated before and after the connection portion 20.

Here, the relaxation circuit includes at least one of the first relaxation circuit RC1 that is the digital phase shift circuit 10 having a larger phase shift amount compared with the standard digital phase shift circuit ST and the second relaxation circuit RC2 that is the digital phase shift circuit 10 having a smaller phase shift amount compared with the standard digital phase shift circuit ST. By using the first relaxation circuit RC1, the concave portion of the distribution of the phase shift amount can be relaxed, and by using the second relaxation circuit RC2, the convex portion of the distribution of the phase shift amount can be relaxed. In this manner, by using the first relaxation circuit RC1 and the second relaxation circuit RC2, it is possible to cope with the distribution of the phase shift amount although a concave portion or a convex portion are included.

Although one embodiment of the present invention has been described above, the present invention is not limited to the above-described embodiment and can be freely changed within the scope of the present invention defined in the claims. For example, in the above-described embodiment, the case where the frequency of the signal S is 30 GHz has been described, but the frequency of the signal S may be other than 30 GHz. For example, the above-mentioned may be any frequency in a frequency band such as a microwave, a quasi-millimeter wave, or a millimeter wave.

In addition, in the above-described embodiment, the configuration in which the digital phase shift circuit 10 includes the capacitor 5 (fifth capacitor) has been described, but a configuration in which the capacitor 5 is not provided may be adopted. In this case, the electronic switch 7d (fourth electronic switch) connected to the lower electrode of the capacitor 5 may not be provided.

### REFERENCE SIGNS LIST

1 Signal line, 2 Inner side line, 2a First inner side line, 2b Second inner side line, 3 Outer side line, 3A Ground layer, 3B Cutout portion, 3a First outer side line, 3b Second outer side line, 4 Ground conductor, 4a First ground conductor, 4b Second ground conductor, 5 Capacitor (fifth capacitor), 6 Connection conductor, 6a to 6f Connection conductor, 7 Electronic switch, 7a, 7b Electronic switch (first electronic switch), 7c Electronic switch, 7d Electronic switch (fourth electronic switch), 8 Switch control unit, 10 Digital phase shift circuit, 10-1 to 10-40 Digital phase shift circuit, 10-41 to 10-43 Relay digital phase shift circuit, 20 Connection portion, 20-1 to 20-3 Connection portion, 23 Connection line, 23a First connection line, 23b Second connection line, 30 Digital phase shift circuit group, 30-1 to 30-4 Digital phase shift circuit group, 51 First connection circuit, 52 Coil (first coil), 53 Capacitor (first capacitor), 54 Electronic switch (second electronic switch), 55 Capacitor (second capacitor), 61 Second connection circuit, 62 Capacitor (third capacitor), 63 Coil (second coil), 64 Electronic switch (third electronic switch), 65 Capacitor (fourth capacitor), 100 Digital phase shifter, 100A to 100C Digital phase shifter, R1 Return current, R2 Return current, RC1 First relaxation circuit, RC2 Second relaxation circuit, S Signal, ST Standard digital phase shift circuit

## Claims

1. A digital phase shifter comprising:
a plurality of digital phase shift circuit groups in which a plurality of digital phase shift circuits are connected in cascade; and
one or more bend type connection portions that connect two of the digital phase shift circuit groups to each other, wherein
the digital phase shift circuit includes at least a signal line, a pair of inner side lines that are provided on both sides of the signal line, a pair of outer side lines that are provided outside the pair of inner side lines, a first ground conductor that is connected to one end of each of the pair of inner side lines and the pair of outer side lines, a second ground conductor that is connected to the other end of each of the pair of outer side lines, and a pair of first electronic switches that are each provided between the other end of each of the pair of inner side lines and the second ground conductor, and is a circuit that is set in a low delay mode in which a return current flows through the pair of inner side lines or a high delay mode in which a return current flows through the pair of outer side lines,
the connection portion includes
a first connection circuit that connects the signal line of a first digital phase shift circuit to the signal line of a second digital phase shift circuit, of two of the digital phase shift circuits, and
a connection line that electrically connects the pair of outer side lines of the first digital phase shift circuit to the pair of outer side lines of the second digital phase shift circuit, and
the first connection circuit includes
a first coil that is connected in series between the signal line of the first digital phase shift circuit and the signal line of the second digital phase shift circuit,
a pair of first capacitors that are connected in parallel on both sides of the first coil, and
a pair of second electronic switches that are each provided on one end side of the pair of first capacitors and that switch whether or not to ground the one end side of the pair of first capacitors.

2. The digital phase shifter according to Claim 1, wherein
the connection portion includes a pair of second capacitors that are connected in parallel on both sides of the pair of first capacitors.

3. A digital phase shifter comprising:
a plurality of digital phase shift circuit groups in which a plurality of digital phase shift circuits are connected in cascade; and
one or more bend type connection portions that connect two of the digital phase shift circuit groups to each other, wherein
the digital phase shift circuit includes at least a signal line, a pair of inner side lines that are provided on both sides of the signal line, a pair of outer side lines that are provided outside the pair of inner side lines, a first ground conductor that is connected to one end of each of the pair of inner side lines and the pair of outer side lines, a second ground conductor that is connected to the other end of each of the pair of outer side lines, and a pair of first electronic switches that are each provided between the other end of each of the pair of inner side lines and the second ground conductor, and is a circuit that is set in a low delay mode in which a return current flows through the pair of inner side lines or a high delay mode in which a return current flows through the pair of outer side lines,
the connection portion includes
a second connection circuit that connects the signal line of a first digital phase shift circuit to the signal line of a second digital phase shift circuit, of two of the digital phase shift circuits, and
a connection line that electrically connects the pair of outer side lines of the first digital phase shift circuit to the pair of outer side lines of the second digital phase shift circuit, and
the second connection circuit includes
a third capacitor that is connected in parallel between the signal line of the first digital phase shift circuit and the signal line of the second digital phase shift circuit,
a pair of second coils that are connected in series on both sides of the third capacitor, and
a third electronic switch that is provided on one end side of the third capacitor and that switches whether or not to ground the one end side of the third capacitor.

4. The digital phase shifter according to Claim 3, wherein
the connection portion includes a fourth capacitor that is connected in parallel between the pair of second coils.

5. The digital phase shifter according to any one of Claims 1 to 4, wherein
at least one of the plurality of digital phase shift circuits is a relaxation circuit that relaxes a distribution of a phase shift amount.

6. The digital phase shifter according to any of Claims 1 to 4, wherein
the digital phase shift circuit includes
a fifth capacitor that is connected between the signal line and at least one of the first ground conductor and the second ground conductor, and
a fourth electronic switch that switches whether or not to connect the fifth capacitor between the signal line and at least one of the first ground conductor and the second ground conductor.

7. The digital phase shifter according to any of Claims 1 to 4, wherein
the first ground conductor and the second ground conductor are configured with a multilayer, and
one layer of the ground conductor that is a multilayer is a ground layer that elongates from the first ground conductor of the first digital phase shift circuit to the second ground conductor of the second digital phase shift circuit to form the connection line.

8. The digital phase shifter according to Claim 7, wherein
the ground layer has a cutout portion.

9. The digital phase shifter according to any of Claims 1 to 4, wherein
the pair of inner side lines includes a first inner side line and a second inner side line, and
the pair of outer side lines includes a first outer side line electrically connected to the first inner side line and a second outer side line electrically connected to the second inner side line.
